Europäisches Patentamt

European Patent Office

Office européen des brevets

(19)

(11) **EP 0 780 937 A1**

(12) **EUROPÄISCHE PATENTANMELDUNG**

(43) Veröffentlichungstag:
25.06.1997 Patentblatt 1997/26

(51) Int. Cl.$^6$: **H01S 3/133**, H01S 3/25

(21) Anmeldenummer: 96119485.9

(22) Anmeldetag: 04.12.1996

(84) Benannte Vertragsstaaten:
**DE FR GB**

(30) Priorität: **19.12.1995 DE 19547469**

(71) Anmelder: **SIEMENS AKTIENGESELLSCHAFT**
**80333 München (DE)**

(72) Erfinder: **Schreck, Hans-Günther, Dipl.-Ing. (FH)**
**80801 München (DE)**

(54) **Schaltungsanordnung zur Regelung zweier Werte der Leistung des von einer Laserdiode abgegebenen optischen Signals**

(57)     In einer Master-Slave-Anordnung mehrerer Laserdioden werden die für die Master-Laserdiode unter Einsatz zweier in analoger Schaltungstechnik ausgeführter Regelkreise durch niederfrequente Umschaltung gewonnenen Stellgrößen für den Vorstrom und den Modulationsstrom zur Steuerung der entprechenden Größen der übrigen, mit hochfrequenten Datensignalen betriebenen Laserdioden herangezogen.

FIG 2

## Beschreibung

Der Anmeldungsgegenstand betrifft eine Schaltungsanordnung zur Regelung zweier Werte der Leistung des von einer Laserdiode abgegebenen optischen Signals bei der

- eine Mehrzahl von gleichen Umgebungsbedingungen ausgesetzten Laserdioden (LDM..LD2) über eine jeweilige Treiberschaltung (T0..T2) mit einem Vorstrom (IV) und einem Modulationsstrom (IM) beaufschlagbar ist
- eine der Mehrzahl von Laserdioden eine Referenzlaserdiode (LDM) bildet, die mit einem Photodetektor (PD) zur Umsetzung eines optischen Signals in ein elektrisches Signal in Wirkverbindung steht
- der Photodetektor ein der Leistung des von der Laserdiode abgegebenen optischen Signal entsprechendes Spannungssignal liefert
- einem ersten Regler (TB) das Spannungssignal und ein Spannungssignal (SWIV) für den Sollwert des Vorstroms der Laserdioden eingangsseitig zugeführt sind
- die Treiberschaltungen jeweils einen ersten mit dem Ausgang des ersten Reglers verbundenen Steuereingang zur Einstellung der Höhe des Vorstromes aufweisen.

Eine derartige Schaltungsanordnung, die in Fachkreisen auch als Master-Slave Anordnung bezeichnet wird, ist aus dem US-Patent 5,337,323 Rokugawa et al., 'Integrated Semicoductor Laser Array Apparatus' bekannt. Dort wird der Vorstrom für eine Referenzlaserdiode auf einen konstanten Wert geregelt und der Vorstrom für die übrigen Laserdioden entsprechend dem Vorstrom für die Referenzlaserdiode nachgeführt. In einer besonderen Ausführungsform erfolgt eine Nachführung der Höhe des Modulationsstromes der übrigen Laserdioden nach Maßgabe der Temperatur. Eine Nachführung des Modulationsstromes nach Maßgabe der Temperatur vermag die Alterung der Laserdioden nicht zu berücksichtigen, wobei zudem die Genauigkeit der Nachführung von dem Grad der Übereinstimmung der Nachbildung mit der tatsächlichen Temperatur-Strombedarf-Abhängigkeit abhängt.

Für einen Empfänger ist bei Empfang eines von einer Laserdiode abgegebenen optischen Signals das als Modulationsgrad bezeichnete Verhältnis von niedrigem optischem Leistungspegel zu hohem optischem Leistungspegel maßgebend. Bei einer Datenübertragung mit einer hohen Datenrate ist eine Übertragung im NRZ (Non-Return-to-Zero) - Format erforderlich. Im NRZ - Format werden die beiden logischen Zustände als niedriger, jedoch von Null abweichender, und als hoher optischer Pegel dargestellt. Mit Alterung und Änderung der Temperatur der Laserdiode verändern sich sowohl der Schwellstrom als auch die Steilheit ihrer Übertragungskennlinie. Bei dem Gegenstand nach dem angegebenen Stand der Technik kann es aufgrund der Alterung der Laserdiode zu einer Abnahme des Modulationsgrades kommen, was zur Verringerung der Reichweite führt.

Zur Regelung sowohl des Vorstromes als auch des Modulationsstromes sind mit zwei Regelkreisen gebildete Regler, wie das Pilotton- und das Modulationshubextraktionsverfahren bekannt geworden. Diese Verfahren werden bevorzugt bei Einzellasern in der Weitverkehrstechnik eingesetzt, wo der hohe Aufwand nicht so sehr ins Gewicht fällt.

Dem Anmeldungsgegenstand liegt das Problem zugrunde, eine Schaltungsanordnung anzugeben, bei der zwei unterschiedliche, mit einer Referenzlaserdiode gewonnene, unabhängig voneinander benötigte Werte für die Leistung eines von einer Laserdiode abgegebenen optischen Signals zur Nachführung entsprechender Werte zumindest einer anderen Laserdiode herangezogen werden.

Das Problem wird bei der eingangs umrissenen Schaltungsanordnung dadurch gelöst, daß

- eine Erfassungseinrichtung (EE) den jeweiligen höchsten Wert und den jeweiligen niedrigsten Wert des von dem Photodetektor abgegebenen Spannungssignals erfaßt
- dem ersten Regler der niedrigste Wert des von dem Photodetektor abgegebenen Spannungssignals zugeführt ist
- einem zweiten Regler (TM) der höchste Wert des Spannungssignals und ein Spannungssignal (SWIM) für den Sollwert des Modulationsstroms eingangsseitig zugeführt sind
- die Treiberschaltungen jeweils einen zweiten mit dem Ausgang des zweiten Reglers verbundenen Steuereingang zur Einstellung der Höhe des Modulationsstromes aufweisen
- die Treiberschaltung der Referenzlaserdiode nach Maßgabe eines einem dritten Steuereingang zugeführten niederfrequenten Signals bezüglich der Lieferung des Modulationsstroms ein- und ausschaltbar ist
- die Treiberschaltungen der übrigen Laserdioden jeweils nach Maßgabe eines einem dritten Steuereingang zugeführten Signals bezüglich der Lieferung des Modulationsstroms ein- und ausschaltbar sind.

Der Anmeldungsgegenstand ermöglicht ein einfaches Zweikreisregelverfahren für mehrere, den gleichen Umgebungsbedingungen ausgesetzte Laserdioden, wobei der anteilige Aufwand je Laserdiode mit steigender Anzahl der Laserdioden verringert ist. Die Regelung arbeitet unabhängig von den durch die übrigen Laserdioden zu übertragenden Daten, also auch unabhängig von der Codierung der zu übertragenden Daten. Die Regelung erfolgt bei frei wählbaren, niedrigen Frequenzen, die leicht beherrschbar sind. Als Photodetektor ist eine Photodiode oder ein Phototransistor mit einer niedrigen Grenzfrequenz einsetzbar. Der Regelkreis ist unter Einsatz von Filtern einfach gegen z.B. aus der Datenübertragung herrührende, hochfrequente Störungen schützbar. Für die Realisierung in integrierten Schaltungen werden wenige Bauelemente in nur einer Technologie benötigt. Durch den geringen Schaltungsaufwand kann eine niedrige Gesamtverlustleistung erzielt werden. Bei den als Slave bezeichneten übrigen Laserdioden, die jeweilige Daten mit hoher Datenrate zu übertragen vermögen, ist eine Auskopplung eines Teiles der abgegebenen optischen Leistung auf eine Fotodiode nicht erforderlich, womit die gesamte abgegebene optische Leistung für die Übertragung zur Verfügung steht.

Gemäß einer besonderen Ausgestaltung des Anmeldungsgegenstandes ist zwischen den Ausgängen des ersten und des zweiten Reglers sowie den Steuereingängen der Treiberschaltungen der weiteren Laserdioden jeweils eine Filterschaltung (FV, FM) angeordnet. Durch diese Maßnahme wirken Schwankungen (Ripple) im optischen Regelsignal, die beispielsweise durch in der Erfassungseinrichtung enthaltene Entladewiderstände entstehen, sich auf die gefilterten Steuerspannungen der übrigen Laserdioden nicht aus.

Der Anmeldungsgegenstand wird im folgenden als Ausführungsbeispiel in einem zum Verständnis erforderlichen Umfang anhand von Figuren näher beschrieben. Dabei zeigen:

Figur 1    eine typische Strom - Leistungs - Kennlinie einer Laserdiode,

Figur 2    eine Schaltungsanordnung, die vom Anmeldungsgegenstand Gebrauch macht,

Figur 3    nähere Einzelheiten einer Treiberschaltung T aus Figur 2,

Figur 4    nähere Einzelheiten der Erfassungseinrichtung EE aus Figur 2.

Figur 5    eine schaltungstechnische Ausführung der Regler TB, TM aus Figur 2,

Figur 6    eine Ausführungsform auf Bauelementeebene des Operationsverstärkers aus Figur 5

Figur 7    eine schaltungstechnische Ausführung des Oazillators OSZ aus Figur 2.

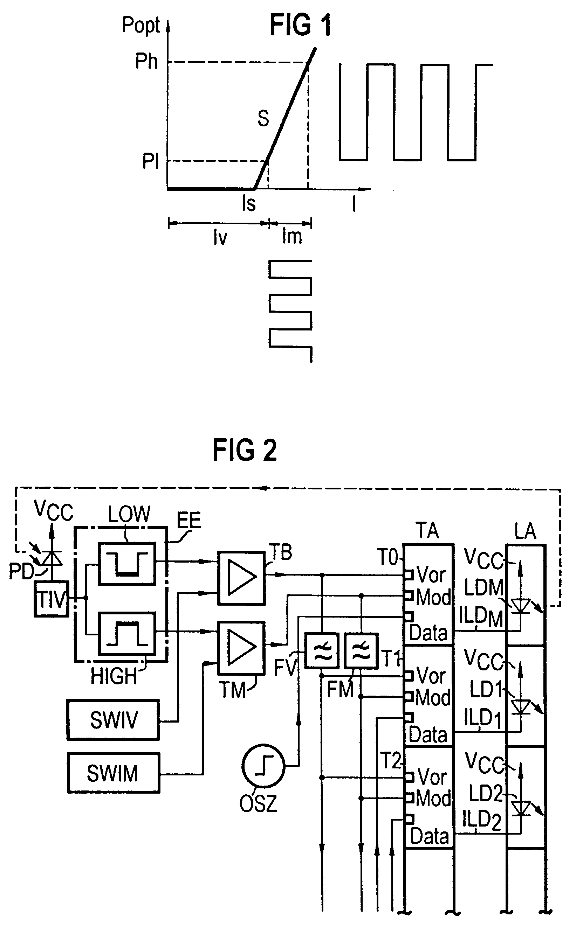

Figur 1 zeigt den hinlänglich bekannten Zusammenhang zwischen dem von einer Laserdiode aufgenommenen Strom I und der von der Laserdiode abgegebenen optischen Leistung Popt. Bis zu einem Schwellenstrom Is gibt die Laserdiode keine nennenswerte optische Leistung ab. Für steigende Stromwerte oberhalb des Schwellenstromes Is nimmt die von der Laserdiode abgegebene optische Leistung annähernd mit der Steigung S zu. Im übrigen sei auf die bekannte, nicht näher dargestellte Tatsache hingewiesen, daß mit steigender Temperatur der Laserdiode der Schwellenstrom ansteigt und die Steilheit abnimmt. Zur Erzielung einer möglichst hohen Datenrate erfolgt die Codierung der Daten im NRZ-Format (Non Return to Zero), d.h. der eine logische Zustand wird durch Ansteuerung der Laserdiode mit dem Vorstrom Iv durch einen niedrigen optischen Pegel Pl und der andere logische Zustand durch Ansteuerung der Laserdiode mit einem um den Modulationsstrom Im erhöhten Vorstrom in ein Signal mit hoher optischer Leistung Ph umgesetzt.

In Figur 2 ist ein Teil der von der Laserdiode LDM abgegebenen optischen Leistung, wie durch eine gestrichelte Linie angedeutet, eines Photodetektors PD, die mit einer Fotodiode, oder einem Fototransistor gebildet sein kann, zugeführt. Der Photodetektor, der von der das hohe Potential führenden Klemme Vcc einer nicht näher dargestellten Betriebsspannungsquelle Vcc-Vss gespeist ist, führt ein Signal, das dem von der Laserdiode abgegebenen optischen Signal entspricht, einem Transimpedanzverstärker TIV zu. Der Transimpedanzverstärker kann im einfachsten Fall durch einen Widerstand gegeben sein, der den von der Laserdiode gelieferten Strom in ein Spannungssignal umsetzt. Das von dem Transimpedanzverstärker abgegebene Spannungssignal ist einer Erfassungseinrichtung EE zugeführt, die jeweils die niedrigste und die höchste Spannung erfaßt und an ihren beiden Ausgängen abgibt. Einem Regler TB (B für: Bias, Vorstrom) ist als Stellgröße der Sollwert SWIV für den Vorstrom und die von der Erfassungseinrichtung gelieferte niedrigste Spannung eingangsseitig zugeführt. Einem Regler TM (M für: Modulation) ist als Stellgröße der Sollwert SWIM für den Modulationsstrom und die von der Erfassungseinrichtung gelieferte höchste Spannung eingangsseitig zugeführt.

Der Ausgang des Reglers TB ist mit dem Eingang VOR einer Treiberschaltung T0 unmittelbar sowie über eine Filterschaltung FV mit den Eingängen VOR der Treiberschaltungen T1, T2, ... verbunden. Der Ausgang des Reglers TM ist mit dem Eingang MOD der Treiberschaltung T0 unmittelbar sowie über eine Filterschaltung FM mit den Eingängen MOD der Treiberschaltungen T1, T2, ... verbunden. Die Filterschaltungen FV, FM weisen Tiefpasseigenschaften auf. Die Treiberschaltung ist nach Maßgabe eines an ihrem Eingang Data zugeführten Signals zwischen der Lieferung des Vorstroms und des Modulationsstroms für die zugehörige Laserdiode umschaltbar. Der Treiberschaltung T0 ist an ihrem Eingang Data ein niederfrequentes Signal, insbesondere ein Taktsignal zugeführt. Den Treiberschaltung T1, T2... ist an ihren Eingängen Data jeweils ein hochfrequentes Signal, insbesondere ein Datensignal zugeführt.

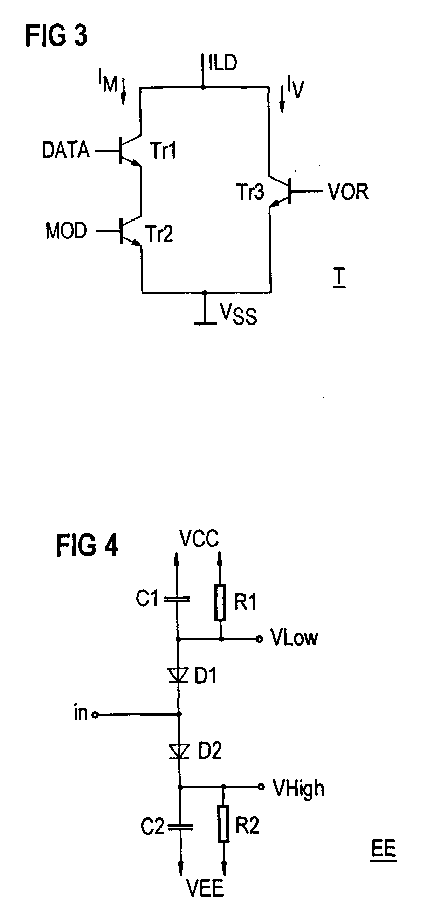

Figur 3 zeigt eine mögliche Ausgestaltung einer Treiberschaltung. Der Serienschaltung eines Transistors Tr1 und eines Transistors Tr2 ist ein Transistor Tr3 parallelgeschaltet. Die Parallelschaltung ist mit ihrer den Emittern zugewandten Verbindung mit der das niedrige Potential aufweisenden Klemme Vss der Betriebsspannungsquelle verbunden. Die den Kollektoren zugewandte Verbindung der Parallelschaltung ist mit der Katode der zugehörigen Laserdiode verbunden. Durch den Zweig der Parallelschaltung mit dem Transistor Tr3 fließt der Vorstrom Iv, dessen Höhe über die Steuerelektrode des Transistors Tr3 einstellbar ist. Der Modulationsstrom Im fließt durch den Zweig der Parallelschaltung mit der Serienschaltung der Transistoren Tr1 und Tr2. An der Steuerelektrode des Transistors Tr2 ist die Höhe des Modulationsstromes einstellbar. An der Steuerelektrode DATA des Transistors Tr1 ist der Modulationsstrom ein- bzw. ausschaltbar.

Nach Maßgabe des niederfrequenten Signals bildet also einmal die Referenzlaserdiode LDM, der Photodetektor PD, die Erfassungseinrichtung EE, der Regler TB und die Treiberschaltung T0 und einmal die Referenzlaserdiode LDM, der Photodetektor PD, die Erfassungseinrichtung EE, der Regler TM und die Treiberschaltung T0 einen geschlossenen Regelkreis.

Neben der betrachteten Laserdiode LDM ist eine Anzahl weiterer Laserdioden LD1..LD2 angeordnet, die den gleichen Umgebungsbedingungen ausgesetzt sind, wie die betrachtete Referenzlaserdiode LDM. Gleiche Umgebungsbedingungen können beispielsweise durch eine enge räumliche Anordnung der Laserdioden zueinander gegeben sein. Gleiche Umgebungsbedingungen sind insbesondere bei einem Laserdiodenarray gegeben, bei dem mehrere Laserdioden zu einer Gruppe von Laserdioden angeordnet sind. Die einzelnen Treiberschaltungen können zu einem Treiberarray TA zusammengefaßt sein, bei dem mehrere gleiche Treiberschaltungen zu einer Gruppe zusammengefaßt sind. Die Schaltungsanordnung bewirkt also eine Nachregelung der Stellgrößen für den Vorstrom und den Modulationsstrom mit einer gegenüber der hohen Datenrate erheblich niedrigeren Frequenz.

Die Schaltungsanordnung kann in analoger Schaltungstechnik, beispielsweise in Bipolar-, MOS(Metall-Oxid-Silicium)- oder GaAs(Gallium-Arsenid)-Technologie ausgeführt sein. Die Regelung der Schaltungsanordnung arbeitet mit zwei Reglern im Parallelbetrieb. Dies ist für die analoge Realisierung günstiger, da das Umschalten eines seriellen Reglers mit Zwischenspeichern analog schwierig zu lösen ist. Zudem können einfache Analogregler mit wesentlich weniger Aufwand realisiert werden als entsprechende Digitalregler.

Fig 4 zeigt eine mögliche schaltungstechnische Ausführung der Erfassungseinrichtung EE. Die Erfassungseinrichtung erfaßt mit einem Spitzenwertdetektor HIGH den höchsten Wert und mit einem Spitzenwertdetektor LOW den niedrigsten Wert der von dem Photodetektor EE abgegebenen Spannung. Die Spitzenwertdetektoren sind jeweils mit der Serienschaltung einer Diode D1, D2 und eines Kondensators C1, C2 gebildet, wobei den Kondensatoren Widerstände R1, R2 parallelgeschaltet sind. Die Widerstände R1 und R2 sind Entladewiderstände, da die Kapazitäten C1, C2 über die Dioden nur geladen, aber nicht entladen werden können. Die Verbindung der Diode D1 mit dem Kondensator C1 ist mit dem Regler TM und die Verbindung der Diode D2 mit dem Kondensator C2 ist mit dem Regler TV verbunden.

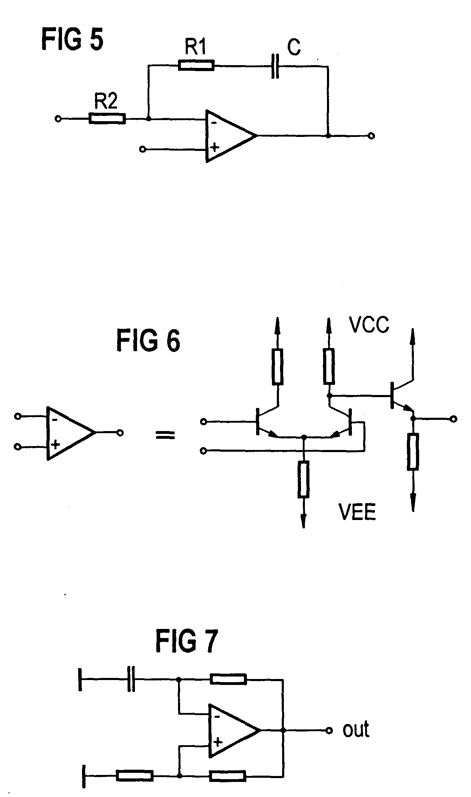

Die Regler TV, TM sind, wie in Fig 5 dargestellt, mit einem einfachen Operationsverstärker als PI-Regler realisiert. Das Widerstandsverhältnis R1/R2 bestimmt die Proportionalverstärkung, die Zeitkonstante $T=R1 \cdot C$ die Grenzfrequenz des I-Glieds.

Der Operationsverstärker aus Fig 5 kann gemäß Fig 6 mit einem Differenzverstärker mit nachgeschaltetem Kollektorverstärker ausgeführt sein.

Fig 7 zeigt eine einfache Ausführungsform des Oszillators in analoger Schaltungstechnik.

Damit sich die beiden Regelkreise nicht gegenseitig beeinflussen, sind die Regelzeitkonstante $T_B$ des Reglers TB und die Regelzeitkonstante $T_M$ des Reglers TM unterschiedlich gewählt. Im angeführten Schema gilt $1/f_{osz} \ll T_B < T_M$ ($f_{osz}$...Oszillatorfrequenz).

**Patentansprüche**

1. Schaltungsanordnung zur Regelung zweier Werte der Leistung des von einer Laserdiode abgegebenen optischen Signals bei der

   - eine Mehrzahl von gleichen Umgebungsbedingungen ausgesetzten Laserdioden (LDM..LD2) über eine jeweilige Treiberschaltung (T0..T2) mit einem Vorstrom (IV) und einem Modulationsstrom (IM) beaufschlagbar ist
   - eine der Mehrzahl von Laserdioden eine Referenzlaserdiode (LDM) bildet, die mit einem Photodetektor (PD) zur Umsetzung eines optischen Signals in ein elektrisches Signal in Wirkverbindung steht
   - der Photodetektor ein der Leistung des von der Laserdiode abgegebenen optischen Signal entsprechendes Spannungssignal liefert
   - einem ersten Regler (TB) das Spannungssignal und ein Spannungssignal (SWIV) für den Sollwert des Vorstroms der Laserdioden eingangsseitig zugeführt sind
   - die Treiberschaltungen jeweils einen ersten mit dem Ausgang des ersten Reglers verbundenen Steuereingang (Vor) zur Einstellung der Höhe des Vorstromes aufweisen

   **dadurch gekennzeichnet,** daß

   - eine Erfassungseinrichtung (EE) den jeweiligen höchsten Wert (VHigh) und den jeweiligen niedrigsten Wert (VLow) des von dem Photodetektor abgegebenen Spannungssignals erfaßt
   - dem ersten Regler der niedrigste Wert des von dem Photodetektor abgegebenen Spannungssignals zugeführt ist
   - einem zweiten Regler (TM) der höchste Wert des Spannungssignals und ein Spannungssignal (SWIM) für den Sollwert des Modulationsstroms eingangsseitig zugeführt sind

- die Treiberschaltungen jeweils einen zweiten mit dem Ausgang des zweiten Reglers verbundenen Steuereingang (Mod) zur Einstellung der Höhe des Modulationsstromes aufweisen
- die Treiberschaltung der Referenzlaserdiode nach Maßgabe eines einem dritten Steuereingang (Data) zugeführten niederfrequenten Signals bezüglich der Lieferung des Modulationsstroms ein- und ausschaltbar ist
- die Treiberschaltungen der übrigen Laserdioden jeweils nach Maßgabe eines einem dritten Steuereingang zugeführten Signals bezüglich der Lieferung des Modulationsstroms ein- und ausschaltbar sind.

2. Schaltungsanordnung nach Anspruch 1,
**dadurch gekennzeichnet,** daß
die Mehrzahl von Laserdioden mit einem mehrere Laserdioden zu einer Baueinheit zusammenfassenden Laserdiodenarray (TA) gebildet ist.

3. Schaltungsanordnung nach Anspruch 2,
**dadurch gekennzeichnet,** daß
die Referenzlaserdiode unter der Mehrzahl von Laserdioden an einem mittleren Platz angeordnet ist.

4. Schaltungsanordnung nach einem der vorstehenden Ansprüche,
**dadurch gekennzeichnet,** daß
zwischen den Ausgängen des ersten und des zweiten Reglers sowie den Steuereingängen der Treiberschaltungen der weiteren Laserdioden jeweils eine Filterschaltung (FV, FM) angeordnet ist.

5. Schaltungsanordnung nach einem der vorstehenden Ansprüche,
**dadurch gekennzeichnet,** daß
das niederfrequente Signal ein von einem Oszillator abgegebenes Taktsignal ist.

6. Schaltungsanordnung nach einem der vorstehenden Ansprüche,
**dadurch gekennzeichnet,** daß
den Treiberschaltungen der weiteren Laserdioden an ihrem dritten Steuereingang jeweils ein Datensignal mit einer hohen Datenrate zuführbar ist.

7. Schaltungsanordnung nach einem der vorstehenden Ansprüche,
**dadurch gekennzeichnet,** daß
der Photodetektor durch eine Photodiode gegeben ist.

8. Schaltungsanordnung nach einem der Ansprüche 1 bis 7,

**dadurch gekennzeichnet,** daß
der Photodetektor durch einen Phototransistor gegeben ist.

# FIG 1

# FIG 2

# FIG 3

# FIG 4

FIG 5

FIG 6

FIG 7

out

**Europäisches Patentamt**

# EUROPÄISCHER RECHERCHENBERICHT

Nummer der Anmeldung

EP 96 11 9485

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | US 5 287 375 A (FUJIMOTO TAKASHI) 15.Februar 1994 | 1,2,7 | H01S3/133 H01S3/25 |
| A | * das ganze Dokument * | 3,5,6 | |
| | --- | | |
| D,A | EP 0 525 684 A (FUJITSU LTD) 3.Februar 1993 * das ganze Dokument * | 1-3 | |
| | --- | | |
| A | EP 0 583 128 A (XEROX CORP) 16.Februar 1994 * Zusammenfassung; Abbildung 3 * | 1,6 | |
| | --- | | |
| P,X | EP 0 725 462 A (SIEMENS AG) 7.August 1996 * das ganze Dokument * | 1 | |
| | ----- | | |

| | |
|---|---|
| | RECHERCHIERTE SACHGEBIETE (Int.Cl.6) |
| | H01S |

Der vorliegende Recherchenbericht wurde für alle Patentansprüche erstellt

| Recherchenort | Abschlußdatum der Recherche | Prüfer |
|---|---|---|
| DEN HAAG | 21.März 1997 | Claessen, L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

                                                                         
& : Mitglied der gleichen Patentfamilie, übereinstimmendes Dokument

EPO FORM 1503 03.82 (P04C03)